(19) Europäisches Patentamt
European Patent Office
Office européen des brevets

(11) **EP 1 257 055 B1**

(12) **EUROPEAN PATENT SPECIFICATION**

(45) Date of publication and mention
of the grant of the patent:
**24.01.2007 Bulletin 2007/04**

(51) Int Cl.:
***H03H 9/05*** *(2006.01)*

(21) Application number: **02010404.8**

(22) Date of filing: **08.05.2002**

(54) **Piezoelectric device**

Piezoelektrische Vorrichtung

Dispositif piézoélectrique

(84) Designated Contracting States:
**DE FR GB**

(30) Priority: **09.05.2001 JP 2001139271**

(43) Date of publication of application:
**13.11.2002 Bulletin 2002/46**

(73) Proprietor: **SEIKO EPSON CORPORATION**
**Shinjuku-ku,**
**Tokyo 163-0811 (JP)**

(72) Inventors:
• **Tanaka, Masako**
**Suwa-shi,**
**Nagano-ken 392-8502 (JP)**
• **Endo, Takashi**
**Suwa-shi,**
**Nagano-ken 392-8502 (JP)**

(74) Representative: **Hoffmann, Eckart**
**Patentanwalt,**
**Bahnhofstrasse 103**
**82166 Gräfelfing (DE)**

(56) References cited:
**US-A- 4 750 246          US-A- 5 422 615**
**US-B1- 6 229 249**

• **PATENT ABSTRACTS OF JAPAN vol. 1997, no. 03, 31 March 1997 (1997-03-31) & JP 08 316732 A (TOYO COMMUN EQUIP CO LTD), 29 November 1996 (1996-11-29)**
• **PATENT ABSTRACTS OF JAPAN vol. 018, no. 603 (E-1632), 16 November 1994 (1994-11-16) & JP 06 232631 A (CITIZEN WATCH CO LTD), 19 August 1994 (1994-08-19)**
• **PATENT ABSTRACTS OF JAPAN vol. 1998, no. 02, 30 January 1998 (1998-01-30) & JP 09 284050 A (TOYO COMMUN EQUIP CO LTD), 31 October 1997 (1997-10-31)**

**Description**

The present invention relates to a piezoelectric oscillator as it is nowadays used in various electronic machines, and in particular to a piezoelectric oscillator having a quartz crystal or other piezoelectric resonator, a semiconductor IC element with an oscillation circuit for driving the resonator, such as an IC chip and the like, and/or discrete electronic components.

Piezoelectric devices, for example, a piezoelectric resonator as frequency reference of electronic circuits, oscillators in which a piezoelectric resonator and an IC chip are sealed in same package, and the like have been widely used in various electronic machines, e.g., OA machines such as information communication machines and computers, and the like, livelihood machines, and the like. Further miniaturization and thinning of the piezoelectric devices have been required with an increasing demand for miniaturization and thinning of these electronic machines, and many surface-mounting type piezoelectric devices for mounting on the circuit boards of the devices have been developed. More recently, piezoelectric devices operated at a high frequency of 80 MHz or more of the fundamental wave have been required corresponding to the high communication frequency and high speed of systems associated with the large capacity and high speed of information transmission in the field of information communication based on portable telephones.

JP-U-6-48216, for example, discloses a surface-mounting type quartz crystal oscillator in which a hollow portion is formed on a laminated circuit board composed of at least three insulating layers; IC chips and electronic components (resistors) are arranged in a cavity formed at the bottom of the hollow portion, a quartz crystal resonator is arranged in the upper part of the hollow portion, a cover is joined to the upper end of the laminated circuit board to seal it to be airtight, and terminal electrodes for an external connection are formed on the rear side of the laminated circuit board. Moreover, in a surface-mounting type piezoelectric oscillator described in JP-A-11-186850, the wiring reactance component is reduced and an improvement of high-frequency characteristics is sought simultaneously with the miniaturization and thinning by arranging a quartz crystal resonator and its driving IC chip in the same case, directly connecting the driving IC chip with solder bumps to wiring patterns formed on the inner bottom of the case and electrically fixing/keeping the resonator above it to electrically connect the resonator to the wiring patterns. Furthermore, in a quartz crystal oscillator described in JP-A-9-107186, an oscillating element and a control element are mounted on a ceramic board, and a resin case where external connection terminals connected to electrodes of the ceramic board are externally arranged covers the ceramic board and then is sealed to prevent wire breakage caused by differences in the thermal expansion coefficients during mounting to the mounting board of another machine.

In order to maintain the frequency constant with high-precision during the use of a piezoelectric oscillator, it is necessary to synchronize with other reference frequencies and to always maintain the frequency at a desirable value or range. Moreover, deviations of the frequency caused by temperature changes and the like must be corrected. To realize this, for example, a function capable of fully correcting the frequency difference relative to a reference frequency with a variable capacitor changed with a control voltage, and the like is required for the piezoelectric oscillator.

As an example of a TCXO (temperature compensated crystal oscillator) JP-A-10-22735 discloses a piezoelectric oscillator in which a bottom wall with a circuit pattern formed for connecting a piezoelectric resonator and an IC chip and an annular sidewall with an opening for receiving them are laminated and burned to form a ceramic base, an adjustment auxiliary portion integrally extended from the bottom wall and the sidewall is arranged on one end side of the ceramic base and adjustment terminals connected to the circuit pattern are formed on an external surface of the ceramic base. This piezoelectric oscillator prevents the occurrence of strain or warp in the manufacture of the ceramic base by writing compensation data into a memory circuit of the IC chip via the adjustment terminals and then separating the adjustment auxiliary portion.

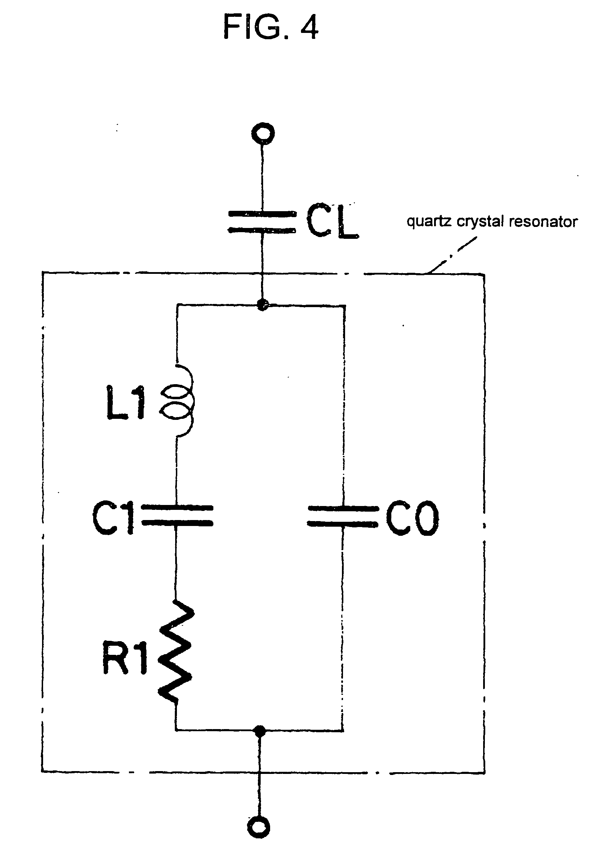

An equivalent circuit of such a voltage controlled crystal oscillator is shown in Fig. 4. Here, the frequency change of the quartz crystal oscillator to the change of a load capacity CL (the circuit capacity) is expressed by the following equation (1). In the field of communication machines used at a very high frequencies, such as portable telephones, the frequency variable width, i.e., $\Delta F$ of the quartz crystal oscillator is as large as possible, therefore $\gamma = C0/C1$ is preferably decreased.

$$\Delta F = \frac{1}{2\gamma\left(1 + \dfrac{CL}{C0}\right)} \tag{1}$$

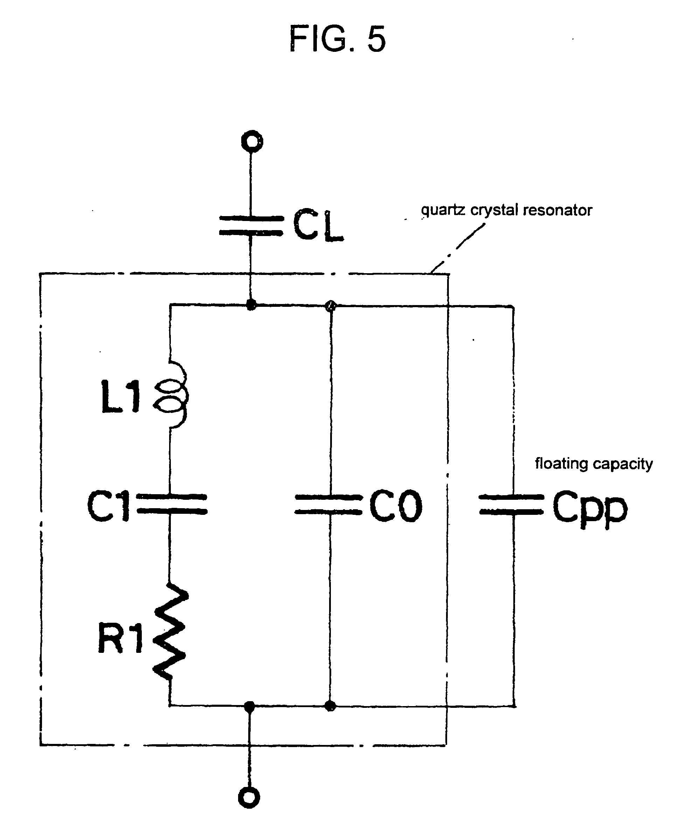

However, an actual quartz crystal oscillator has a floating capacity $C_{pp}$ as shown in Fig. 5. In this case, the apparent capacity of the parallel connection of C0 and $C_{pp}$ becomes (C0 + $C_{pp}$), and the frequency change $\Delta F'$ becomes

correspondingly:

$$\Delta F' = \frac{1}{2\gamma'\left(1 + \dfrac{CL}{C0 + C_{pp}}\right)} \qquad (2)$$

with $\gamma' = \dfrac{C0 + C_{pp}}{C1}$

From the equation (2), it follows that if the floating capacity $C_{pp}$ increases, the frequency change $\Delta F$ to the load capacity CL decreases and that the higher the frequency, the greater the floating capacity $C_{pp}$. This represents a big problem because it requires a high accuracy for an AT cut quartz crystal resonator operating at a very high frequency.

The electrostatic capacity of the resonator itself, an electrostatic capacity between lead-out electrodes formed on the resonator, an electrostatic capacity between terminals of a package and an electrostatic capacity between the resonator and the package, and the like are considered as the reasons for such a floating capacity. The floating capacity caused by the package is $C_{pp} \approx C0$ at 80 MHz or higher in various piezoelectric materials, especially in the case of quartz crystal, therefore its influence on the frequency change is large.

As with the quartz crystal oscillators described in JP-A-11-186850 and JP-A-9-107186, in a structure where a quartz crystal resonator and electronic components such as an IC for driving, and the like are loaded in same package, the floating capacity generated between them decreases and therefore is favorable, but it is feared that a gas generated from the bumps of electronic components and electrode pads as well as an adhesive for fixing them is adsorbed on the surface of the resonator and exerts a bad influence on the vibration characteristics thereof. The decrement of frequency caused by the adsorption of such a gas is expressed by the following equation (3), and the higher the frequency, the greater the decrement. For example, when the same amount of gas is adsorbed on the quartz crystal resonator, the frequency decrement of 1 ppm at a frequency of 20 MHz becomes 25 ppm at a frequency of 100 MHz.

$$\Delta f = \frac{W_{ab}}{p_q \cdot V_q} \cdot f^2 \qquad (3)$$

Here,

> $W_{ab}$: the weight of adsorbed gas on electrode surface (g/cm$^2$)
> $P_q$: the density of quartz crystal (g/cm$^3$)
> $V_q$: the propagation velocity in quartz crystal
> f: the resonance frequency

Thus, a quartz crystal resonator vibrating at a very high frequency is very sensitive to ambient gas and is easily affected. Therefore it is desirable that no other electronic components exist in same atmosphere. For the quartz crystal oscillator described in JP-A-8-316732, in order to prevent a deviation of the resonance frequency caused by the adsorption of a gas generated from an adhesive for joining a cover after sealing the case, a first receiver is arranged in the case and a second receiver is arranged at its bottom, an oscillation circuit such as IC, and the like is received in the first receiver, a quartz crystal resonator is loaded in the second receiver, sealed with a cap and built into the case, then the frequency is measured. Then the frequency is adjusted to compensate for residual strain in the manufacture of the resonator and the strain caused by fixing it to the case. However, the oscillator described in the this document has the problem that the entire package cannot be made sufficiently thin and miniaturized because another air-tight sealed empty chamber for the quartz crystal resonator is arranged in an air-tight sealed container to make the cover into a dual structure.

US 6,229,249 B1 discloses a piezoelectric device according to the pre-characterizing portion of claim 1. In this prior art, the first region and the second region are provided on two opposite main surfaces of the board. This structure contradicts the tendency to devices as thin as possible.

It's the object of the present invention to provide a piezoelectric device, in which a piezoelectric resonator and electronic components constituting its oscillation circuit are loaded in same package, and that effectively prevents the reduction of a the range within which the frequency can be set caused by a floating capacity due to the adsorption of a gas generated from the electronic components and wiring, package or wiring structure, and the like, adjusts the frequency with high accuracy corresponding to the requirements of miniaturization and thinning, and is particularly suitable for high-frequency oscillators with a fundamental wave of 80 MHz or higher.

This object is achieved by a piezoelectric device as claimed in claim 1. Preferred embodiments of the invention are subject-matter of the dependent claims.

With this solution, high frequency stability and aging characteristics are obtained by sealing the piezoelectric resonator air-tightly in the first space whose atmosphere is separate from that around the electronic components, because of no floating capacity caused by the adsorption of a gas generated from the electronic components and the like after sealing, no occurrence of floating capacity as in a wiring structure in which the wiring patterns formed on multiple laminated sheets are interlayer connected on account of a wiring structure in which the piezoelectric resonator and the electronic components are directly connected to the wiring patterns formed on the board which is the bottom plate of the package, and no fear of producing a deviation of frequency caused by such a floating capacity. Moreover, frequency adjustment can be made with high accuracy by adjusting the electronic components of the second region in a state in which the piezoelectric resonator is sealed to be air-tight. Furthermore, unlike the quartz crystal oscillator described in the above JP-A-8-316732, thinning and miniaturization of entire package is possible because there is no need to make the cover into a dual structure.

Because the first sidewall has a height above that of the second sidewall, joining the cover is easily accomplished and a reliable resin sealing of the second region is facilitated. Particularly, when the cover consists of a metal plate and is joined to the first sidewall by seam welding, a space necessary for interlocking jigs with the cover and the seal ring can be secured above the second sidewall. In that case, furthermore, the deviation of the frequency caused by the adsorption of the gas after sealing the piezoelectric resonator does not occur and superior aging characteristics are obtained with high frequency stability because the first void space can be maintained in an atmosphere where there is no undesirable gas, such as a gas that can be generated in the case of joining the cover with a low-melting glass.

In the embodiment of claim 5, since the frequency of the piezoelectric resonator sealed in the first space can be precisely measured via the exclusive test terminals before the resin sealing of the second region is performed, and the wiring patterns are not exposed to the external of package after the resin sealing of the second region, there is no fear of external corrosion and noise which exert a negative influence, and the stability of frequency and vibration characteristics is secured .

Preferred embodiments of the invention are described in detail hereafter, with reference to the attached drawings, in which:

Fig. 1(A)      is a plan view showing a quartz crystal oscillator according to an embodiment of the present invention,

FIG. 1(B)      is a longitudinal sectional view of the oscillator in Fig. 1(A);

Fig. 2      is an exploded perspective view of a base shown in Fig. 1;

Fig. 3      is a diagram showing, for both an oscillator according to the invention and an oscillator according to the prior art, the deviation of frequency from a predetermined frequency against the applied voltage;

Fig. 4      is a circuit diagram showing a theoretical equivalent circuit of a quartz crystal resonator.

Fig. 5      is a circuit diagram showing an actual equivalent circuit model of a quartz crystal resonator.

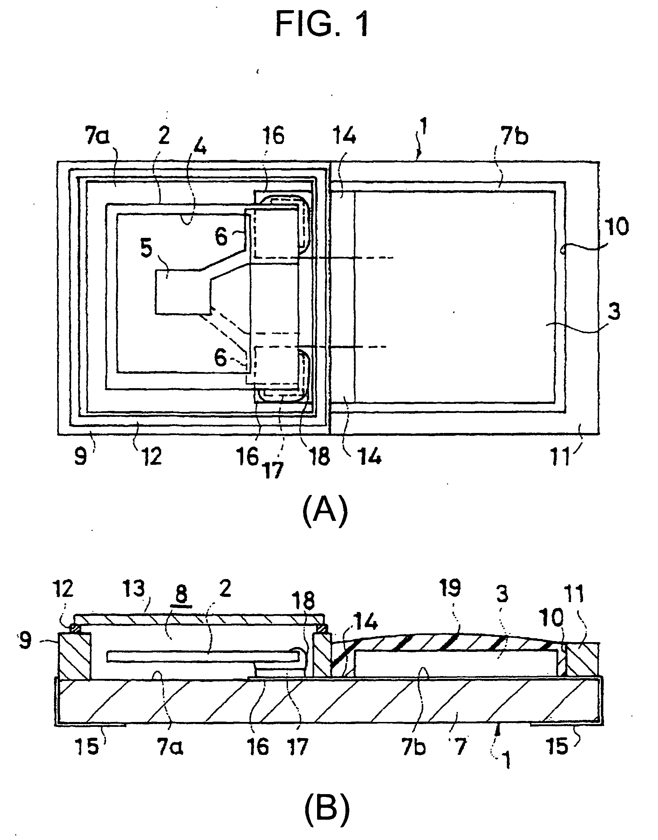

Fig. 1(A) and (B) schematically show the construction of a quartz crystal oscillator which is a first embodiment of the piezoelectric device according to the present invention. In this oscillator, an AT cut quartz crystal resonator 2 and an IC chip 3 constituting an oscillation circuit for driving it are included in a package 1 made of an insulating material. The resonator 2 of this embodiment, has a so-called reverse mesa structure, wherein an excitation electrode 5 is formed roughly at the center of a depressed thin-wall part 4 arranged on both a front surface and a rear face of the resonator forming a rectangle, and a pair of connection electrodes 6 are led out therefrom.

The package 1 has a base comprising a board 7, made of a ceramic material, that comprises on one principal face, i.e., the top side, a first region 7a for mounting the resonator 2 and a second region 7b for mounting the IC chip 3. A rectangular first sidewall 9 which encloses the first region 7a and delimits a first space 8 for receiving the resonator 2 and a rectangular second sidewall 11 which encloses the second region 7b and delimits a second space 10 for receiving the IC chip 3 are adjoined and integrally arranged on the top side of the board 7. The first sidewall 9 is formed higher than the second sidewall 11, and a metal cover 13 is air-tightly joined to the upper end of sidewall 9 via a seal ring 12.

Wiring patterns 14 for connecting the resonator 2 and the IC chip 3 are formed on the top side of the board 7 and connected to external terminals 15 arranged on the other principal face, i.e., the rear side of the board 7. These wiring patterns and external terminals are generally formed by screen printing metal wiring materials such as W, Mo, and the like on the surface of the ceramic board and then plating Ni, Au thereon.

The wiring patterns 14 define a pair of connection terminals 16 for the resonator 2 arranged in the first region 7a. Roughly rectangular electrode pads 17 which are made of a suitable conducting material and gold plated on their surface are formed on the connection terminals 16, respectively.

The connection electrodes 6 are glued to corresponding electrode pads 17 with a conductive adhesive 18; therefore the resonator 2 is fixed on one side and supported almost horizontally and connected electrically.

In this embodiment, the two connection terminals 16 are arranged directly the inside the first sidewall 9 near to the second region 7b around the middle. This enables minimizing the length of wiring for connecting the resonator 2 and the IC chip 3 thereby minimizing the influence of noise, and the like.

The wiring patterns 14 also define connection terminals (not shown) for the IC chip arranged in the second region 7b, and the IC chip 3 is face-down bonded to these connection terminals, e.g., by a flip chip mode. The IC chip can also be connected by wire bonding, but face-down bonding is favorable in reducing the height and seeking to thin the entire package. The IC chip 3 and the wiring patterns 14 exposed in the second region 7b are resin sealed with a potting material 19 filled into the second space 10. This protects the IC chip and wiring patterns as well as preventing a short circuit between the electrodes and wiring due to foreign matter.

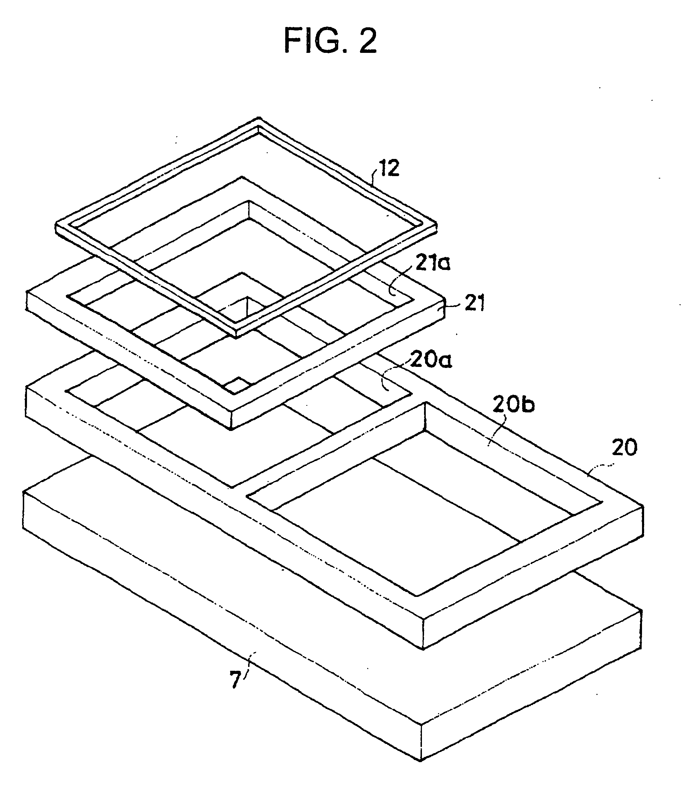

The base of the embodiment consists of a laminated structure of ceramic material sheets as shown in Fig. 2. A ceramic sheet 20 having an opening 20a for constructing the lower part of the first space and an opening 20b for constructing the second space 10 and a ceramic sheet 21 having an opening 21a for constructing the upper part of the first space 8 are laminated and integrated on the top side of the board 7 where the wiring patterns 14 are pre-formed. A metal seal ring 12 is further joined onto the ceramic sheet 21. Such a laminated structure is well known in the field of packaging piezoelectric devices and is favorable because many bases can be simultaneously manufactured with large ceramic sheets.

The oscillator of the present embodiment is assembled according to the following procedure. First, the base formed by laminating the ceramic sheets as described above in relation to Fig. 2 is prepared, the resonator 2 is bonded to the electrode pads 17 corresponding to the connection electrodes 6 with the conductive adhesive 18 and by that the resonator has one side fixed in a cantilever fashion in the first space 8. After the conductive adhesive 18 is fully hardened and any undesirable gas is fully removed from within the first space 8, the base is disposed in a vacuum atmosphere or a nitrogen atmosphere, the cover 13 is seam welded to the upper end of the first sidewall 9 via the seal ring 12, and then the first space 8 is sealed in the vacuum or nitrogen atmosphere. Because the first sidewall 9 is higher than the second sidewall 11, a space necessary for interlocking jigs with the cover 13 and the seal ring 12 during the seam welding can be secured above the second sidewall 11. Moreover, undesirable gas as in the case of joining the cover 13 with a resin or a low-melting glass does not occur, the first space 8 can be maintained in an atmosphere free of such a gas, the deviation of frequency caused by gas adsorption after sealing the quartz crystal resonator 2 does not occur, and thus high frequency stability and superior aging characteristics are obtained.

The fundamental vibration characteristics of the resonator 2 are measured by using the wiring patterns 14 for connection of IC chip 3 arranged in the second region 7b. This enables to preliminarily exclude inferior products which do not display desirable vibration characteristics and seek an improvement of yield and a reduction of cost as a whole of manufacturing steps of the oscillator.

Subsequently, the IC chip 3 is face-down bonded in the second region 7b. After the oscillation characteristics of the IC chip 3 are confirmed using the external terminals 15 on the rear side of the board 7 and frequency adjustment is conducted by adjusting the IC chip 3 according to demand, a suitable potting material 18 is injected into the second space 10 surrounded by the second sidewall 11, and the second space 10 is filled so as to perfectly seal the IC chip and the exposed part of the wiring patterns. This enables completion of an oscillator in accordance with the present invention.

A second embodiment of present invention differs from the first embodiment by a voltage controlled variable capacitor mounted as a discrete electronic part in addition to the IC chip 3 in the second region 7b of the board 7 and then similarly resin sealed. This enables obtaining a voltage controlled crystal oscillator which can be made thin and miniaturized and has a high frequency stability and superior aging characteristics as is the case with the above-mentioned first embodiment.

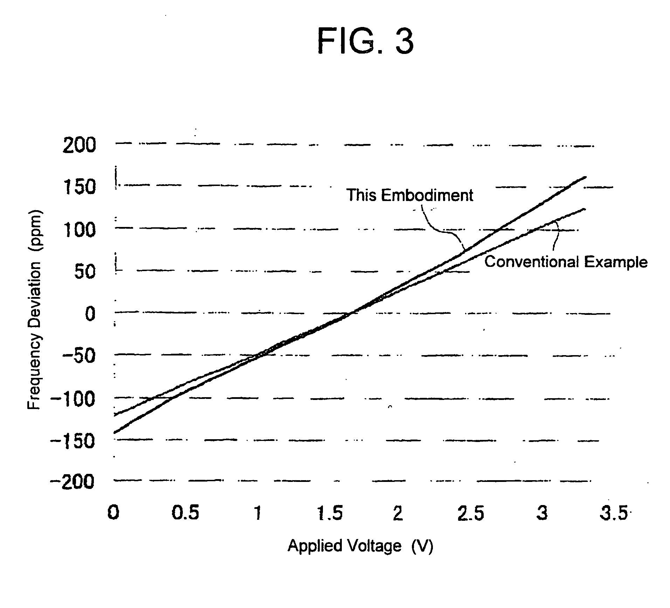

Fig. 3 shows results obtained by measuring the variable amount of frequency (ppm) of such a voltage controlled crystal oscillator, the horizontal axis is the applied voltage (V) (voltage applied to a variable capacitance diode), and the vertical axis is the frequency deviation (ppm) = the variable amount of frequency $\Delta F')/2$. In the same diagram, a comparison is made with a prior art quartz crystal oscillator in which the resonator is sealed in a package and its oscillation circuit is connected as with individual discrete parts; as will be appreciated, in the oscillator of present invention, the variable amount of frequency sharply increases by about 20% by essentially reducing the floating capacity due to the , package and wiring structure.

The frequency deviation relating to the elapsed time is measured to analyze the aging characteristics for the same voltage controlled crystal oscillator of the present invention. As a result, no essential changes or only very small changes of the frequency against the elapse of time are found and superior aging characteristics could be confirmed as compared with the prior art oscillator in which the quartz crystal resonator and the IC chip comprising the oscillation circuit are loaded in same atmosphere of the same package.

A third embodiment differs from any of the first and second embodiments in that the wiring patterns 14 have test terminals exclusively used for the resonator 2 arranged in the second region 7b of the board 7. The vibration characteristics of the resonator 2 can be measured in a state of being mounted the IC chip 3 in the second region 7b by arranging such individual test terminals.

A fourth embodiment differs from any of the preceding embodiments in that the second sidewall 11 enclosing the second region 7b is omitted from the top side of the board 7. In this case, the IC chip 3 and the wiring patterns 14 mounted in the second region 7b are preferably sealed with a molding resin having a higher viscosity than the potting material used in the embodiment of Fig. 1.

The present invention is also suitable in the case of resonators made of various piezoelectric materials other than quartz crystal.

The present invention accomplishes the special effects described below with the construction as described above.

In accordance with the present invention, since the piezoelectric resonator is air-tightly sealed in the first space with an atmosphere isolated from the electronic components, no adsorption of gas generated from the electronic components exists in this atmosphere. Moreover, since the resonator and the electronic components are directly connected to the wiring patterns formed on the board, there is no fear that a floating capacity occurs and causes deviation in frequency due to the gas adsorption by such a piezoelectric resonator and the wiring structure of package. Accordingly, the present invention enables displaying high frequency stability and aging characteristics as well as high-accuracy frequency adjustment by adjusting the electronic components provided in the second region. A surface-mounting piezoelectric device that can be miniaturized and thinned is thus obtained. Particularly, the present invention enables increasing the variable width of frequency in the case of applying it to a voltage controlled high-frequency oscillator, and thus it is favorable for the use in communication machines.

**Claims**

1. A piezoelectric device, comprising a package (1) having
   a board (7) having a wiring pattern (14) formed on one principal face thereof and a first region (7a) and a second region (7b), the first region (7a) being enclosed by a first sidewall (9) arranged on the board (7) so as to define a first space (8) inside the first sidewall (9), and a cover (13) joined to the end of the first sidewall (9) remote from the board (7) so as to seal the first space (8) air-tightly,
   a piezoelectric resonator (2) connected to the wiring patterns (14) and mounted in the first space (8), and electronic components connected to the wiring patterns (14) and mounted in the second region (7b), the electronic components and the wiring patterns (14) in the second region (7b) being resin sealed the second region (7b) being enclosed by a second sidewall (11) so as to define a second space (10) for receiving the electronic components therein,
   **characterized in that** said wiring pattern, first region (7a) and second region (7b) are formed on said one principal face, and said second sidewall (11) has a height lower than that of the first sidewall (9).

2. The device of Claim 1, wherein the electronic components constitute an oscillation circuit using said resonator (2) as the frequency determining element.

3. The device of Claim 1 or 2, wherein the electronic components include a voltage-controlled variable capacitor.

4. The device of any one of the preceding Claims, wherein the electronic components and the wiring patterns (14) of the second region (7b) are resin sealed with a potting material (19) injected into the space surrounded by the second sidewall (11).

5. The device of any one of Claims 1 to 4, wherein the wiring patterns (14) have test terminals for said resonator (2).

6. The device of any one of Claims 1 to 5, wherein the cover (13) consists of a metal plate and is joined to the first sidewall (9) by seam welding.

7. The device of any one of Claims 1 to 6, wherein the first sidewall (9) is formed by laminating one or more ceramic sheets (20, 21) with an opening (20a, 21a) defining the first space (8) onto the board (7).

**Patentansprüche**

1. Piezoelektrische Vorrichtung ein Gehäuse (1) aufweisend, mit
einer Platine (7) mit einem Verdrahtungsmuster (14), die auf einer Hauptfläche derselben ausgebildet ist, und einer ersten Zone (7a) sowie einer zweiten Zone (7b), wobei die erste Zone (7a) von einer auf der Platine (7) angeordneten ersten Seitenwand (9) umgeben ist, so dass ein erster Raum (8) innerhalb der ersten Seitenwand (9) gebildet wird, und einer Abdeckung (13), die mit dem der Platine (7) abgewandten Ende der ersten Seitenwand (9) verbunden ist, um den ersten Raum (8) luftdicht abzuschließen;
einem piezoelektrischen Resonator (2), der mit den Verdrahtungsmustern (14) verbunden und im ersten Raum (8) installiert ist, und
elektronischen Bauelementen, die mit den Verdrahtungsmustern (14) verbunden und in der zweiten Zone (7b) installiert sind, wobei die elektronischen Bauelemente und die Verdrahtungsmuster (14) in der zweiten Zone (7b) mit Harz abgedichtet sind und die zweite Zone (7b) von einer zweiten Seitenwand (11) umgeben ist, so dass ein zweiter Raum (10) zur Aufnahme der elektronischen Bauelemente gebildet wird,
**dadurch gekennzeichnet, dass** die Verdrahtungsmuster, die erste Zone (7a) und die zweite Zone (7b) auf der einen Hauptfläche ausgebildet sind, und die zweite Seitenwand (11) niedriger ist als die ersten Seitenwand (9).

2. Vorrichtung nach Anspruch 1, bei der die elektronischen Bauelemente eine Schwingschaltung bilden, wobei der Resonator (2) als das die Frequenz bestimmende Element dient.

3. Vorrichtung nach Anspruch 1 oder 2, bei der die elektronischen Bauelemente einen spannungsgesteuerten variablen Kondensator enthalten.

4. Vorrichtung nach einem der vorigen Ansprüche, bei der die elektronischen Bauelemente und die Verdrahtungsmuster (14) der zweiten Zone (7b) mit einem Vergussmaterial (19) harzabgedichtet sind, das in den von der zweiten Seitenwand (11) umgebenen Raum eingespritzt wird.

5. Vorrichtung nach einem der Ansprüche 1 bis 4, bei der die Verdrahtungsmuster (14) Testanschlüsse für den Resonator (2) haben.

6. Vorrichtung nach einem der Ansprüche 1 bis 5, bei der die Abdeckung (13) aus einem Metallblech besteht und durch Nahtschweißen mit der ersten Seitenwand (9) verbunden ist.

7. Vorrichtung nach einem der Ansprüche 1 bis 6, bei der die erste Seitenwand (9) durch Auflaminieren einer oder mehrerer Keramikschichten (20, 21) mit einer den ersten Raum (8) auf der Platine (7) bildenden Öffnung (20a, 21a) gebildet wird.

**Revendications**

1. Dispositif piézoélectrique comprenant un boîtier (1) comportant :

une carte (7) sur une face principale de laquelle est formé un motif (14) de câblage et ayant une première région (7a) et une deuxième région (7b), la première région (7a) étant fermée par une première paroi (9) latérale disposée sur la carte (7), de manière à définir un premier espace (8) à l'intérieur de la première paroi (9) latérale, et un couvercle (13) uni à l'extrémité de la première paroi (9) latérale, éloignée de la carte (7) afin sceller le premier espace (8) de manière étanche à l'air,
un résonateur (2) piézoélectrique connecté aux motifs (14) de câblage et monté dans le premier espace (8), et
des composants électroniques connectés aux motifs (14) de câblage et montés dans la deuxième région (7b), les composants électroniques et les motifs (14) de câblage de la deuxième région (7b) étant scellés par de la résine, la deuxième région (7b) étant fermée par une deuxième paroi (11) latérale, de manière à définir un deuxième espace (10) pour y recevoir les composants électroniques.
**caractérisé en ce que** le motif de câblage, la première région (7a) et la deuxième région (7b) sont formés sur ladite une face principale, et la deuxième paroi (11) latérale a une hauteur inférieure à celle de la première paroi (9) latérale.

2. Dispositif suivant la revendication 1, dans lequel les composants électroniques constituent un circuit oscillant utilisant le résonateur (2), en tant qu'élément de détermination de fréquence.

**3.** Dispositif suivant la revendication 1 ou 2, dans lequel les composants électroniques comprennent un condensateur variable commandé en tension.

**4.** Dispositif suivant l'une quelconque des revendications précédentes, dans lequel les composants électroniques et les motifs (14) de câblage de la deuxième région (7b) sont scellés par de la résine à l'aide d'une matière (19) d'enrobage injectée dans l'espace entouré par la deuxième paroi (11) latérale.

**5.** Dispositif suivant l'une quelconque des revendications 1 à 4, dans lequel les motifs (14) de câblage comportent des bornes d'essai pour le résonateur (2).

**6.** Dispositif suivant l'une quelconque des revendications 1 à 5, dans lequel le couvercle (13) se compose d'une plaque métallique et est uni à la première paroi (9) latérale par soudage à la molette.

**7.** Dispositif suivant l'une quelconque des revendications 1 à 6, dans lequel la première paroi (9) latérale est formée par stratification d'une ou de plusieurs feuilles (20, 21) de céramique ayant une ouverture (20a, 21a) définissant le premier espace (8) sur la carte (7).

# FIG. 1

(A)

(B)

# FIG. 2

# FIG. 3

# FIG. 4

quartz crystal resonator

# FIG. 5